# EUROPEAN PATENT SPECIFICATION

(11) **EP 4 537 047 B1**
(45) Date of publication and mention of the grant of the patent: **08.04.2026**
(21) Application number: 23738380.7
(22) Date of filing: 06.06.2023
(51) Int. Cl.: G01B 7/00, B23K 1/08, B23K 3/08, H05K 3/34

(54) **POSITION DETECTION DEVICE**
POSITIONSDETEKTIONSVORRICHTUNG
DISPOSITIF DE DÉTECTION DE POSITION

(30) Priority: 06.06.2022 CN 202210633179
(43) Date of publication of application: 16.04.2025
(73) Proprietor: Illinois Tool Works Inc., Glenview, IL 60025 (US)
(72) Inventor: NI, Yuhua, Glenview, Illinois 60025 (US)
(74) Representative: HGF
(86) International application number: PCT/US2023/067967
(87) International publication number: WO 2023/240060

(56) References cited:
- US-A1- 2012 024 938
- US-A1- 2020 156 169

## Description

### Technical Field

The present application relates to the field of position detection devices, and more particularly to a position detection apparatus for detecting a tin cylinder.

### Background

A wave soldering includes a tin cylinder. The tin cylinder may move in an up-to-down direction, thereby adjusting the distance to a PCB board so that peaks of liquid metal tin contact the PCB board. However, in the prior art, motion distance detection of the tin cylinder is inaccurate. Relevant prior art are US 2020/156169 and US 2012/024938.

### Summary

Examples of this application may address at least some of the above-described issues. The present application provides a position detection apparatus, comprising a bottom plate, an abutting member, a trigger member, a trigger member, and a distance sensor. The abutting member is movably disposed on the bottom plate. The trigger member is connected to the abutting member. The induction member is disposed on the trigger member. The distance sensor is disposed on the bottom plate. The induction member and the distance sensor are disposed such that: the distance sensor is capable of detecting a movement distance of the induction member when the abutting member drives the induction member to move, and wherein the trigger member bypasses the distance sensor.

According to the above-described position detection apparatus, the abutting member, the trigger member, and the induction member are movable in an upward and downward direction relative to the bottom plate, and the trigger member is disposed to bypass the distance sensor above the distance sensor.

According to the above-described position detection apparatus, the distance sensor is fixedly connected to the bottom plate to avoid motion of the distance sensor relative to the bottom plate.

According to the above-described position detection apparatus, the trigger member includes a first lever, a second lever, and a third lever that are sequentially connected, and the first lever, the second lever, and the third lever enclose to form a cavity having a downward opening for disposing the distance sensor.

According to the above-described position detection apparatus, the distance sensor has a sensing plane toward the induction member having an induction plane toward the distance sensor, the sensing plane being arranged in parallel with the induction plane.

According to the above-described position detection apparatus, the distance sensor is fixedly connected to the bottom plate via a fixed plate and configured to cause the sensing plane to directly face the induction plane.

According to the above-described position detection apparatus, the sensing plane and the induction plane are formed in an up-to-down direction.

According to the above-described position detection apparatus, the bottom plate and the abutting member have a guide slot and a guide rail extending in an up-to-down direction that cooperate with each other.

According to the above-described position detection apparatus, the trigger member has a first position and a second position and is movable between the first position and the second position. The position detection apparatus further includes a reset member configured to move the trigger member from the second position to the first position so that the abutting member (104) connected to the trigger member abuts against a tin cylinder.

According to the above-described position detection apparatus, the reset member is a spring, a lower end of the spring is connected to the bottom plate, and an upper end of the spring is connected to the trigger member.

The position detection apparatus of the present application has a higher detection accuracy of relative movement of the induction member to the distance sensor.

### Brief Description of the Drawings

Features and advantages of the present application may be better understood by reading the following detailed description with reference to the accompanying drawings, in which same reference numerals represent some parts throughout the accompanying drawings, where:

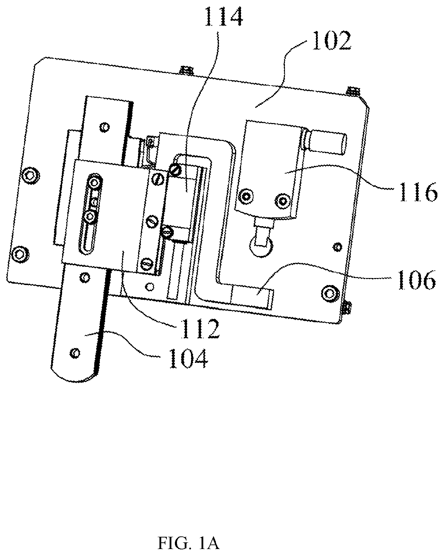

FIG. 1A is a stereoscopic view of a position detection apparatus according to the present application;

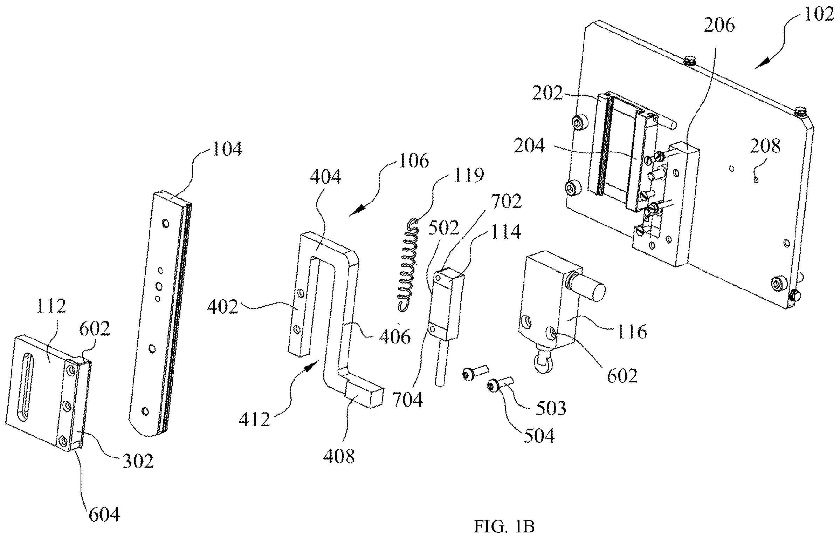

FIG. 1B is an exploded view of the position detection apparatus shown in FIG. 1A; and

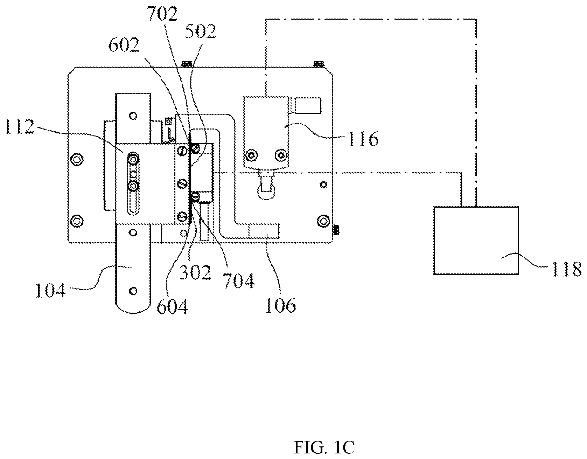

FIG. 1C is a front view of the position detection apparatus shown in FIG. 1A.

### Detailed Description

Various specific embodiments of the present application will be described below with reference to the attached drawings that form a part of the present specification. It should be understood that in the following drawings, the same parts use the same reference numerals.

Various specific embodiments of the present application will be described below with reference to the attached drawings that form a part of the present specification. It should be understood that while terms denoting orientation, such as "front," "rear," "upper," "lower," "left," "right," etc., are used in the present application to describe various exemplary structural parts and elements of the present application, these terms are used herein for convenience of illustration only, and these terms are determined based on the exemplary orientations shown in the attached drawings. Since the examples disclosed in the present application may be disposed in different orientations, these terms denoting orientation are for illustrative purposes only and should not be considered as limiting.

Ordinal words such as "first" and "second" used in this application are used for distinction and identification only and have no other meaning, and do not represent a particular order or association unless specifically specified. For example, the term "first position" by itself does not imply presence of a "second position" and the term "second position" by itself does not imply presence of a "first position".

FIG. 1A is a stereoscopic view of a position detection apparatus according to the present application, FIG. 1B is an exploded view of the position detection apparatus shown in FIG. 1A, and FIG. 1C is a front view of the position detection apparatus shown in FIG. 1A. As shown in FIGS. 1A-1C, the position detection apparatus includes a bottom plate 102, an abutting member 104, a trigger member 106, an induction member 112, a distance sensor 114, a limiting sensor 116, and a control apparatus 118. The abutting member 104, the trigger member 106, the induction member 112, the distance sensor 114, and the limiting sensor 116 are disposed on the bottom plate 102. The abutting member 104, the trigger member 106, and the induction member 112 are connected and are movable in an upward and downward direction relative to the bottom plate 102. The abutting member 104, the trigger member 106, and the induction member 112 have a first position and a second position and are movable between the first position and the second position. The second position is higher than the first position. The first position and the second position will be detailed below.

As shown in FIGS. 1A-1C, the bottom plate 102 is provided with a first guide bar 202 and a second guide bar 204 that are disposed at a distance in a left-to-right direction to accommodate the abutting member 104. The opposite sides of the first and second guide bars 202, 204 are each provided with a recess that extends in the up-to-down direction. The abutting member 104 is formed generally along the up-to-down direction. Protrusions on the right and left sides of the abutting member 104 that extend in the up-to-down direction are receivable in the recess. The recess and the protrusion are capable of forming a guide slot and a guide rail to enable movement of the abutting member 104 in the up-to-down direction relative to the bottom plate 102. The lower end of the abutting member 104 is a free end that is capable of abutting against a tin cylinder (not shown) which when moves upwardly will abut against the abutting member 104 such that the abutting member 104 moves upwardly with the tin cylinder.

It may be understood that while a guide slot is provided on the bottom plate 102 and a guide rail is provided on the abutting member 104 as shown in the present application, in other examples, a guide slot and a guide rail extending in the up-to-down direction are provided on the bottom plate 102 and the abutting member 104 that cooperate with each other.

As shown in FIGS. 1A-1C, the induction member 112 is fixed on the abutting member 104. The induction member 112 is generally a cube having an induction plane 302 located to the right. As the abutting member 104 moves between the first position and the second position, the induction plane 302 also moves between the first position and the second position.

As shown in FIGS. 1A-1C, the trigger member 106 is fixed on the induction member 112, thereby being fixedly connected to the abutting member 104. The trigger member 106 includes a first lever 402, a second lever 404, a third lever 406, and a fourth lever 408. The first and third levers 402, 406 are formed in the up-to-down direction and are disposed at a distance in the left-to-right direction. The second lever 404 extends in the left-to-right direction. The second lever 404 is connected to the upper end of the first and third levers 402, 406 and encloses with the first and third levers 402, 406 to form a cavity 412 having a downward opening for disposing the distance sensor 114. The fourth lever 408 is connected to the lower end of the third lever 406 and extends towards the right side. The free end of the fourth lever 408 is used to contact the limiting sensor 116.

As shown in FIGS. 1A-1C, a fixed plate 206 is provided on the bottom plate 102. The fixed plate 206 is fixedly connected to the bottom plate 102 and extends towards by a distance from the front side of the bottom plate 102. The distance sensor 114 is connected to the bottom plate 102 after connecting to the front side of the fixed plate 206. The distance sensor 114 is fixedly connected to the bottom plate 102 by the fixed plate 206, thereby avoiding motion of the distance sensor 114 relative to the bottom plate 102. The distance sensor 114 is configured to detect a distance of motion of the induction member 112. In particular, the distance sensor 114 is in communication connection to the control apparatus 118. The control apparatus 118 is capable of receiving a distance signal from the distance sensor 114, representing a distance of motion of the induction member 112 to represent a distance of motion of the abutting member 104.

In the present application, a sensing plane 502 is provided on the side of the distance sensor 114 towards the induction member 112. The sensing plane 502 is disposed in parallel with the induction plane 302 of the induction member 112 and directly faces the induction plane 302 through the arrangement of the fixed plate 206. The area of the induction plane 302 is greater than the area of the sensing plane 502 such that the induction plane 302 can be detected by the sensing plane 502 as it moves. In particular, the abutting member 104, the trigger member 106, and the induction member 112 are located in the first position when an upper surface 602 of the induction plane 302 is flush with an upper surface 702 of the sensing plane 502 (as shown in FIG. 1C); the abutting member 104, the trigger member 106, and the induction member 112 are located in the second position when a lower surface 604 of the induction plane 302 is flush with a lower surface 704 of the sensing plane 502. As the induction plane 302 moves relative to the sensing plane 502, the sensing plane 502 is able to detect a distance of motion of the induction plane 302 and transmit data to the control apparatus 118. As one example, the distance sensor 114 and the induction member 112 are inductive range finders. As another example, the distance sensor 114 and the induction member 112 are incremental bearingless linear encoders MIL10 produced by Baumer.

As shown in FIGS. 1A-1C, the position detection apparatus further includes a reset member 119. The reset member 119 is configured to move the abutting member 104, the trigger member 106, and the induction member 112 from the second position to the first position. In the present application, the reset member 119 is a spring. The lower end of the spring is connected to the bottom plate 102, the upper end of the spring is connected to the trigger member 106, and the spring is in a stretched state when the trigger member 106 is located in the first position. As such, regardless of whether the abutting member 104, the trigger member 106, and the induction member 112 are in the first or second position, the spring applies a downward force to the trigger member 106 to keep the lower end of the abutting member 104 abutting against the tin cylinder.

As shown in FIGS. 1A-1C, a limiting sensor 116 is disposed to the upper right of the bottom plate 102 for contacting the fourth lever 408 of the trigger member 106. When the trigger member 106 is in contact with the limiting sensor 116, the trigger member 106 is in an extreme position. The limiting sensor 116 is in communication connection to the control apparatus 118 and is capable of transmitting a limiting signal to the control apparatus 118. When the trigger member 106 moves upwardly to the extreme position, the trigger member 106 contacts the limiting sensor 116 such that the limiting sensor 116 sends a limiting signal to the control apparatus 118, indicating that the tin cylinder has reached the extreme position. In the present application, the limiting sensor 116 is fixed to the bottom plate 102 via a screw 503. In particular, a through hole 602 is provided on the limiting sensor 116. A hole 208 is provided on the bottom plate 102 corresponding to the through hole 602. The hole 208 is threaded on the inner wall to fit with the screw 503. The screw 503 is capable of passing through the through hole 602 after passing through a gasket 504, and subsequently fix with the threads of the hole 208, fixing the limiting sensor 116 to the bottom plate 102.

In the prior art, the quality of welding between a PCB board and a component to be soldered is poor. The inventors have found that this is due to the inaccuracy of motion distance detection of the tin cylinder and the inability to control the distance of the tin cylinder from the PCB board well, resulting in the inability to control the distance of the peak of liquid metal tin in the tin paste well from the PCB board. For example, in some machines, the actual distance from the top of the tin cylinder to the PCB board is 5 mm, but the detection value measured from the distance sensor 114 is 6 mm; the actual distance from the top of the tin cylinder to the PCB board is 8 mm, but the detection value measured from the distance sensor 114 is 9 mm. In other machines, the actual distance from the top of the tin cylinder to the PCB board is 5 mm, but the detection value measured from the distance sensor 114 is 4 mm; the actual distance from the top of the tin cylinder to the PCB board is 8 mm, but the detection value measured from the distance sensor 114 is 7 mm. This detection value, which deviates from the actual distance, causes the peak of the liquid metal tin to be too far or too close from the PCB board, thereby affecting the weld quality. The inventors further have found that this deviation in the actual distance from the detection value is due to the arrangement of the induction member 112 and the distance sensor 114. In particular, in the prior art, the distance sensor 114 is connected on the bottom plate 102 via a bridge-like connector in order to avoid interference between the distance sensor 114 and the trigger member 106 moving with the induction member 112. Because the thickness of the entire position detection apparatus in the front-rear direction is limited to less than 3 cm, the bridge-like connector is formed of a thin plate. Although the bridge-like connector is fixedly connected to the bottom plate 102, because the distance sensor 114 has a certain weight, and there is a temperature rise during operation of the tin cylinder, the connector also shakes when the connector is thermally expanded. This prevents the sensing plane 502 from remaining parallel to the induction plane 302 at all times, resulting in a deviation in the actual distance from the detection value. In the present application, the inventors dispose the trigger member 106 to bypass the distance sensor 114. More specifically, the trigger member 106 is disposed to bypass over the distance sensor 114 such that motion of the trigger member 106 does not interfere with the distance sensor 114. The distance sensor 114 is fixedly connected to the bottom plate 102, thereby ensuring that the sensing plane 502 remains parallel with the induction plane 302, thereby increasing the detection accuracy of the relative motion of the induction member to the distance sensor.

## Claims

1. A position detection apparatus, comprising:
a bottom plate (102);
an abutting member (104) moveably disposed on the bottom plate (102);
a trigger member (106) connected to the abutting member (104);
an induction member (112) disposed on the trigger member (106); and
a distance sensor (114) disposed on the bottom plate (102);
**characterised in that**
the induction member (112) and the distance sensor (114) are disposed such that the distance sensor (114) is capable of detecting a movement distance of the induction member (112) when the abutting member (104) drives the induction member (112) to move, and wherein the trigger member (106) bypasses the distance sensor (114).

2. The position detection apparatus according to Claim 1, wherein:
the abutting member (104), the trigger member (106), and the induction member (112) are movable in an upward and downward direction relative to the bottom plate (102), and the trigger member (106) is disposed to bypass the distance sensor (114) above the distance sensor (114).

3. The position detection apparatus according to Claim 1, wherein:
the distance sensor (114) is fixedly connected to the bottom plate (102) to avoid movement of the distance sensor (114) relative to the bottom plate (102).

4. The position detection apparatus according to Claim 2, wherein:
the trigger member (106) comprises a first lever (402), a second lever (404), and a third lever (406) that are sequentially connected, the first lever (402), the second lever (404), and the third lever (406) enclose to form a cavity (412) having a downward opening for disposing the distance sensor (114).

5. The position detection apparatus according to Claim 3, wherein:
the distance sensor (114) has a sensing plane (502) toward the induction member (112) having an induction plane (302) toward the distance sensor (114), the sensing plane (502) being arranged in parallel with the induction plane (302).

6. The position detection apparatus according to Claim 5, wherein:
the distance sensor (114) is fixedly connected to the bottom plate (102) via a fixed plate (206) and configured to cause the sensing plane (502) to directly face the induction plane (302).

7. The position detection apparatus according to Claim 5, wherein:
the sensing plane (502) and the induction plane (302) are formed in an up-to-down direction.

8. The position detection apparatus according to Claim 1, wherein:
the bottom plate (102) and the abutting member (104) have a guide slot and a guide rail extending in an up-to-down direction that cooperate with each other.

9. The position detection apparatus according to Claim 1, wherein:
the trigger member (106) has a first position and a second position and is movable between the first position and the second position; and
the position detection apparatus further comprises a reset member (119) configured to move the trigger member (106) from the second position to the first position so that the abutting member (104) connected to the trigger member (106) abuts against a tin cylinder.

10. The position detection apparatus according to Claim 9, wherein:
the reset member (119) is a spring, a lower end of the spring is connected to the bottom plate (102), and an upper end of the spring is connected to the trigger member (106).

## Patentansprüche

1. Positionserfassungsvorrichtung, aufweisend:
eine Bodenplatte (102);
ein Anlageelement (104), das beweglich auf der Bodenplatte (102) angeordnet ist;
ein Auslöseelement (106), das mit dem Anlageelement (104) verbunden ist;
ein Induktionselement (112), das auf dem Auslöseelement (106) angeordnet ist; und
einen Abstandssensor (114), der auf der Bodenplatte (102) angeordnet ist;
**dadurch gekennzeichnet, dass**
das Induktionselement (112) und der Abstandssensor (114) so angeordnet sind, dass der Abstandssensor (114) in der Lage ist, eine Bewegungsdistanz des Induktionselements (112) zu erfassen, wenn das Anlageelement (104) das Induktionselement (112) so antreibt, dass es sich bewegt, und wobei das Auslöseelement (106) den Abstandssensor (114) umgeht.

2. Positionserfassungsvorrichtung nach Anspruch 1, wobei:
das Anlageelement (104), das Auslöseelement (106) und das Induktionselement (112) in einer Aufwärts- und Abwärtsrichtung in Bezug auf die Bodenplatte (102) beweglich sind, und das Auslöseelement (106) so angeordnet ist, dass es den Abstandssensor (114) oberhalb des Abstandssensors (114) umgeht.

3. Positionserfassungsvorrichtung nach Anspruch 1, wobei:
der Abstandssensor (114) fest mit der Bodenplatte (102) verbunden ist, um eine Bewegung des Abstandssensors (114) in Bezug auf die Bodenplatte (102) zu verhindern.

4. Positionserfassungsvorrichtung nach Anspruch 2, wobei:
das Auslöseelement (106) einen ersten Hebel (402), einen zweiten Hebel (404) und einen dritten Hebel (406) aufweist, die sequenziell miteinander verbunden sind, wobei der erste Hebel (402), der zweite Hebel (404) und der dritte Hebel (406) so geschlossen sind, dass sie einen Hohlraum (412) mit einer nach unten gerichteten Öffnung zum Anordnen des Abstandssensors (114) bilden.

5. Positionserfassungsvorrichtung nach Anspruch 3, wobei:
der Abstandssensor (114) eine Erfassungsebene (502) in Richtung des Induktionselements (112) aufweist, das eine Induktionsebene (302) in Richtung des Abstandssensors (114) aufweist, wobei die Erfassungsebene (502) parallel zu der Induktionsebene (302) angeordnet ist.

6. Positionserfassungsvorrichtung nach Anspruch 5, wobei:
der Abstandssensor (114) über eine feste Platte (206) fest mit der Bodenplatte (102) verbunden ist und so konfiguriert ist, dass er bewirkt, dass die Erfassungsebene (502) direkt der Induktionsebene (302) zugewandt ist.

7. Positionserfassungsvorrichtung nach Anspruch 5, wobei:
die Erfassungsebene (502) und die Induktionsebene (302) in einer Auf-ab-Richtung ausgebildet sind.

8. Positionserfassungsvorrichtung nach Anspruch 1, wobei:
die Bodenplatte (102) und das Anlageelement (104) einen Führungsschlitz und eine Führungsschiene, die sich in einer Auf-ab-Richtung erstrecken, aufweist, die miteinander zusammenwirken.

9. Positionserfassungsvorrichtung nach Anspruch 1, wobei:
das Auslöseelement (106) eine erste Position und eine zweite Position aufweist und zwischen der ersten Position und der zweiten Position bewegbar ist; und
die Positionserfassungsvorrichtung ferner ein Rückstellelement (119) aufweist, das so konfiguriert ist, dass es das Auslöseelement (106) von der zweiten Position in die erste Position bewegt, sodass das mit dem Auslöseelement (106) verbundene Anlageelement (104) an einem Zinnzylinder anliegt.

10. Positionserfassungsvorrichtung nach Anspruch 9, wobei:
das Rückstellelement (119) eine Feder ist, ein unteres Ende der Feder mit der Bodenplatte (102) verbunden ist und ein oberes Ende der Feder mit dem Auslöseelement (106) verbunden ist.

## Revendications

1. Appareil de détection de position, comprenant :
une plaque inférieure (102) ;
un élément de butée (104) disposé de manière mobile sur la plaque inférieure (102) ;
un élément de déclenchement (106) connecté à l'élément de butée (104) ;
un élément d'induction (112) disposé sur l'élément de déclenchement (106) ; et
un capteur de distance (114) disposé sur la plaque inférieure (102) ;
**caractérisé en ce que**
l'élément d'induction (112) et le capteur de distance (114) sont disposés de telle sorte que le capteur de distance (114) est capable de détecter une distance de déplacement de l'élément d'induction (112) lorsque l'élément de butée (104) entraîne le déplacement de l'élément d'induction (112), et dans lequel l'élément de déclenchement (106) contourne le capteur de distance (114).

2. Appareil de détection de position selon la revendication 1, dans lequel :
l'élément de butée (104), l'élément de déclenchement (106), et l'élément d'induction (112) sont mobiles dans une direction vers le haut et vers le bas par rapport à la plaque inférieure (102), et l'élément de déclenchement (106) est disposé pour contourner le capteur de distance (114) au-dessus du capteur de distance (114).

3. Appareil de détection de position selon la revendication 1, dans lequel :
le capteur de distance (114) est raccordé de manière fixe à la plaque inférieure (102) pour éviter le déplacement du capteur de distance (114) par rapport à la plaque inférieure (102).

4. Appareil de détection de position selon la revendication 2, dans lequel :
l'élément de déclenchement (106) comprend un premier levier (402), un deuxième levier (404) et un troisième levier (406) qui sont raccordés séquentiellement, le premier levier (402), le deuxième levier (404) et le troisième levier (406) enferment pour former une cavité (412) ayant une ouverture vers le bas pour disposer le capteur de distance (114).

5. Appareil de détection de position selon la revendication 3, dans lequel :
le capteur de distance (114) a un plan de détection (502) vers l'élément d'induction (112) ayant un plan d'induction (302) vers le capteur de distance (114), le plan de détection (502) étant agencé parallèlement au plan d'induction (302).

6. Appareil de détection de position selon la revendication 5, dans lequel :
le capteur de distance (114) est raccordé de manière fixe à la plaque inférieure (102) par l'intermédiaire d'une plaque fixe (206) et configuré pour amener le plan de détection (502) à faire directement face au plan d'induction (302).

7. Appareil de détection de position selon la revendication 5, dans lequel :
le plan de détection (502) et le plan d'induction (302) sont formés selon une direction de haut en bas.

8. Appareil de détection de position selon la revendication 1, dans lequel :
la plaque inférieure (102) et l'élément de butée (104) ont une fente de guidage et un rail de guidage s'étendant dans une direction de haut en bas qui coopèrent l'un avec l'autre.

9. Appareil de détection de position selon la revendication 1, dans lequel :
l'élément de déclenchement (106) a une première position et une deuxième position et est mobile entre la première position et la deuxième position ; et
l'appareil de détection de position comprend en outre un élément de réinitialisation (119) configuré pour déplacer l'élément de déclenchement (106) de la deuxième position à la première position de sorte que l'élément de butée (104) raccordé à l'élément de déclenchement (106) bute contre un cylindre d'étain.

10. Appareil de détection de position selon la revendication 9, dans lequel :
l'élément de réinitialisation (119) est un ressort, une extrémité inférieure du ressort est raccordée à la plaque inférieure (102), et une extrémité supérieure du ressort est raccordée à l'élément de déclenchement (106).
